# EUROPEAN PATENT APPLICATION

(11) **EP 1 530 303 A1**
(43) Date of publication of application: **11.05.2005**
(21) Application number: 04025688.5
(22) Date of filing: 28.10.2004
(51) Int. Cl.: H04B 7/005, H03F 1/02

(54) **Power control in a mobile communication system**

(30) Priority: 07.11.2003 KR 2003078769
(71) Applicant: LG Electronics Inc., Seoul (KR)
(72) Inventor: Kim, Sang-Woo, Seodaemun-gu, Seoul (KR)
(74) Representative: von Hellfeld, Axel, Dr. Dipl.-Phys.

(57) **Abstract**

A system and method for controlling power of a module is disclosed. A signal processing system comprises a controller and an adapting unit. The controller outputs a control signal according to a reference driving voltage corresponding to requested transmission power. The adapting unit controls a driving voltage according to the control signal. An amplifier is driven according to the driving voltage. The requested transmission power is transmitted from a base station. The controller calculates output power according to power received from the base station. The controller determines a driving voltage of the amplifier corresponding to the calculated output power.

## Description

### BACKGROUND OF THE INVENTION

### 1. Field of the Invention

The present invention relates to a mobile communication system and, more particularly, to a system and a method for controlling operational power of a PAM (Power Amplifier Module) for a mobile terminal.

### 2. Description of the Related Art

In a mobile communication system, there is a need for extending the battery life of a mobile terminal. In a conventional mobile terminal, a power amplifier module (PAM) of the terminal is directly supplied from a battery.

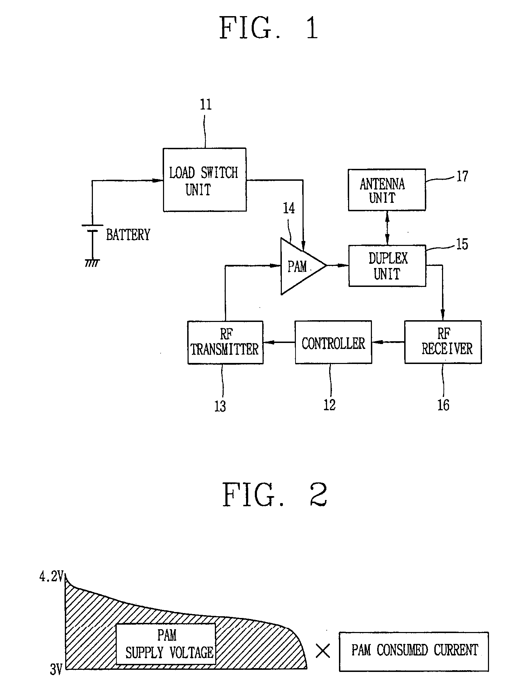

Referring to Fig. 1, a conventional mobile terminal includes a load switch unit 11, a controller 12, a radio frequency unit 16, an RF transmitter 13, a PAM 14, a duplex unit 15, an RF receiver 16, and an antenna unit 17.

The load switch unit 11 supplies a voltage of a battery as a driving voltage of the PAM 14. The controller 12 (e.g., mobile station modem) receives a signal which has been amplified or frequency-converted in the radio frequency unit (RF Rx Unit) 16. The controller 12 transmits a suitable response to an RF transmitter 13 by a closed loop power control. The RF transmitter 13 receives an output signal of the controller 12. The output signal is amplified, frequency-converted and outputted. The PAM 14 amplifies an output signal of the RF transmitter 13 and outputs it. The duplex unit 15 separates frequencies associated with transmission and reception. The RF receiver 16 amplifies and frequency-converts a signal received through the duplex unit 15. The antenna unit 17 transmits and receives a signal from a base station to a mobile terminal. A load switch unit 11 supplies the voltage of the battery to the PAM 14.

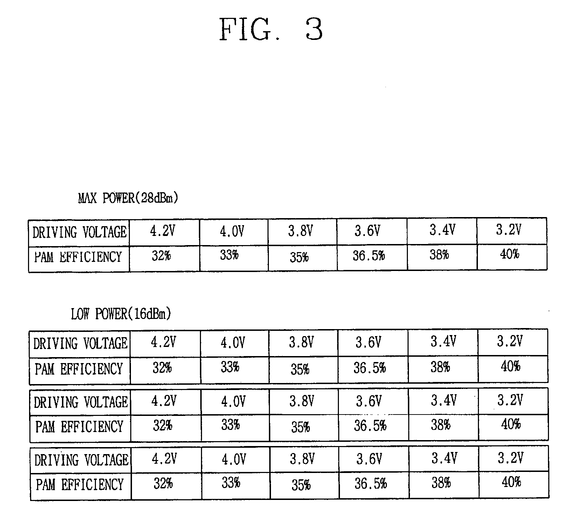

Referring to Fig. 2, the voltage of the battery is generally about 3.0~4.2V. An initial voltage supplied to the PAM 14 is 4.2V and when power of the battery is completely used up, the voltage of the PAM 14 is lowered to 3V.

Referring to Fig. 3, to produce a maximum output power of 28 dBm, a driving voltage of 3.2 volts produces 40% power added efficiency and a driving voltage of 4.0 volts produces 32 % power added efficiency. Accordingly, there is a need for an improved controller with a lower driving voltage that results in higher efficiency of the power amplifier module and less overheating of the mobile terminal.

### SUMMARY OF THE INVENTION

Features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings.

The invention is directed to a system and a method for controlling the operational power of a power amplifier module in a mobile communication system. In the system, a controller utilizes a switch unit and a DC/DC converter level to adjust the supplied battery power to the power amplifier module. The controller, in one embodiment, uses a pulse width modulated signal as a control signal to periodically adjust the battery power supplied to the power amplifier module.

In one embodiment, the system for controlling power of a power amplifier module (PAM) comprises an antenna unit for transmitting and receiving a communication signal between a base station and a mobile terminal, and a duplex unit for separating a transmission and reception frequency. An RF receiving unit amplifies and frequency-converts a signal received through the antenna unit and the duplex unit, and outputs an RF receiving unit output signal.

A controller, such as a mobile station modem, receives the RF receiving unit output signal, and calculates a reference voltage corresponding to a driving voltage for the power amplifier. The controller transmits a control signal to a switch unit.

The system further comprises a DC/DC converter that receives a control signal from the controller. If the voltage of the battery becomes equal to an output voltage defined by the controller, the DC/DC converter lowers the voltage to a defined output voltage.

On the other hand, if the voltage of the battery is greater than the output voltage, then the output voltage is supplied to the power amplifier module. An RF transmitter unit receives, amplifies, and frequency converts the output signal of the controller producing an RF transmitting unit output signal. The RF transmitter unit output signal is supplied to the power amplifier module. The power amplifier module transmits an amplified version of an output of the RF transmitting unit to the duplex unit.

In one embodiment, the controller calculates a suitable driving voltage according to power received from a base station. The driving voltage is transmitted to the power amplifier through the DC/DC converter. In yet another embodiment, when the voltage of the battery is optimized, the controller transmits a control signal to turn-off the DC/DC converter. The switching unit is turned-on. The voltage of the battery is supplied to the PAM.

Additional features and advantages of the invention will be set forth in the description which follows, and in part will be apparent from the description, or may be learned by practice of the invention. It is to be understood that both the foregoing general description and the following detailed description of the present invention are exemplary and explanatory and are intended to provide further explanation of the invention as claimed.

These and other embodiments will also become readily apparent to those skilled in the art from the following detailed description of the embodiments having reference to the attached figures, the invention not being limited to any particular embodiments disclosed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

Features, elements, and aspects of the invention that are referenced by the same numerals in different figures represent the same, equivalent, or similar features, elements, or aspects in accordance with one or more embodiments.
Figure 1 is a block diagram illustrating a conventional mobile terminal.
Figure 2 is a graph illustrating the power consumption of a PAM (Power Amplifier Module) for a conventional mobile terminal.
Figure 3 is a table illustrating efficiency of the PAM according to a driving voltage through using a conventional mobile terminal.
Figure 4 is a block diagram to illustrate controlling operational power of a PAM in a mobile terminal in accordance with an embodiment of the invention.
Figure 5 is a block diagram to illustrate controlling operational power of a PAM in the mobile terminal in accordance with an embodiment of the invention.
Figure 6 is a graph showing generation of a pulse width modulation (PWM) signal in accordance with an embodiment of the invention.
Figure 7 is a table showing a change in an output voltage in accordance with a change in a level of a reference voltage in accordance with an embodiment of the invention.
Figure 8 is a graph illustrating power consumption of a PAM in the mobile terminal in accordance with an embodiment of the invention.
Figure 9 is a table illustrating data of power consumed in the PAM of the mobile terminal in accordance with on embodiment of the invention.
Figure 10 is a table illustrating an efficiency comparison of mobile terminals based on driving voltage, temperature, and battery usage time using the system and the method of the invention compared to prior mobile terminals.
Figure 11 is a block diagram illustrating a UTRAN in accordance with the systems and methods of the invention.

### DETAILED DESCRIPTION OF THE PREFERRED EMBODIMENTS

The invention relates to a system and a method for controlling the operational power of a power amplifier module in a mobile communication system. The system controller of the invention provides a solution to overheating of a mobile terminal and extending the battery usage time of a mobile terminal. Although the invention is illustrated with respect to a power amplifier module, it is contemplated that the invention may be utilized anytime it is desired for increasing power efficiency when transmitting or receiving signals from one location to another location.

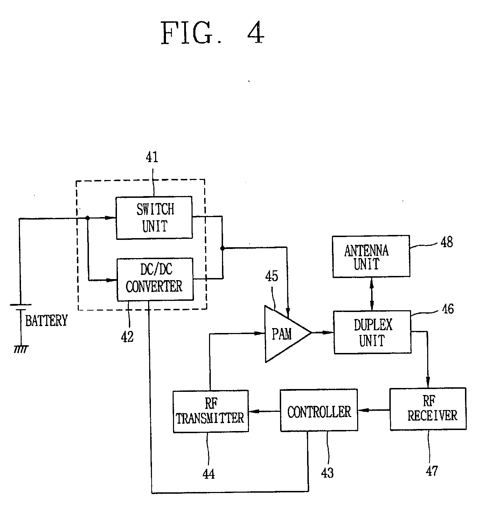

Referring to Fig. 4, an antenna unit 48 transmits and receives a communication signal between a base station and a mobile terminal. A duplex unit 46 separates a transmission frequency from a reception frequency. In this same system, an RF receiving unit 47 amplifies, frequency-converts a signal received the duplex unit 46 and outputs an RF receiving unit output signal. A controller 43 (e.g., mobile station modem) receives an output signal of the RF receiving unit, calculates a reference voltage corresponding to a suitable output voltage (PAM driving voltage), and transmits a corresponding control signal.

A switch unit 41 receives the control signal from the controller 43. The switch unit 41 is turned-on to supply a voltage of a battery as a driving voltage of a power amplifier module (PAM) 45 when the voltage of the battery becomes equal to an output voltage defined by the controller 43. The DC/DC converter 42 receives the control signal from the controller 43. The DC/DC converter 42 lowers a level of the voltage of the battery to an output voltage defined by the controller 43 if the voltage of the battery is greater than the output voltage. The lowered voltage level is supplied to the PAM 45.

An RF transmitting unit 44 receives, amplifies, and frequency-converts the output signal of the controller 43 to produce an RF transmitting unit output signal. The PAM 45 operates upon receiving driving power from the switch unit 41 or the DC/DC converter 42. The PAM 45 amplifies and transmits the output of the RF transmitting unit 44 to the duplex unit. The controller 43 calculates a suitable output power according to received transmission requirement from a base station. The controller 43 transmits a driving voltage for the PAM 45 corresponding to the calculated output power through the DC/DC converter 42.

In one example, maximum efficiency of the PAM 45 occurs for a PAM driving voltage of 3.4V, which desired voltage was determined by the controller 43. An output voltage of 3.4V is compared with a voltage of the battery. If the voltage of the battery is greater than 3.4V, the controller transmits a control signal to turn off the switch unit 41 to prevent supplying a battery voltage greater than 3.4V. In this example, the DC/DC converter 42 is turned-on to drop the voltage of the battery from greater than 3.4V to 3.4V. The voltage of the battery is supplied to the PAM 45. In one example, the DC/DC converter 42 lowers the voltage of the battery to 3.4 V as determined by the controller 43 through PWM (Pulse Width Modulation).

In another example, if the voltage of the battery is equal to the output voltage 3.4V, the controller 43 transmits a control signal to turn off the DC/DC converter 42 and turn on the switch unit 41. The battery voltage is supplied to the PAM 45.

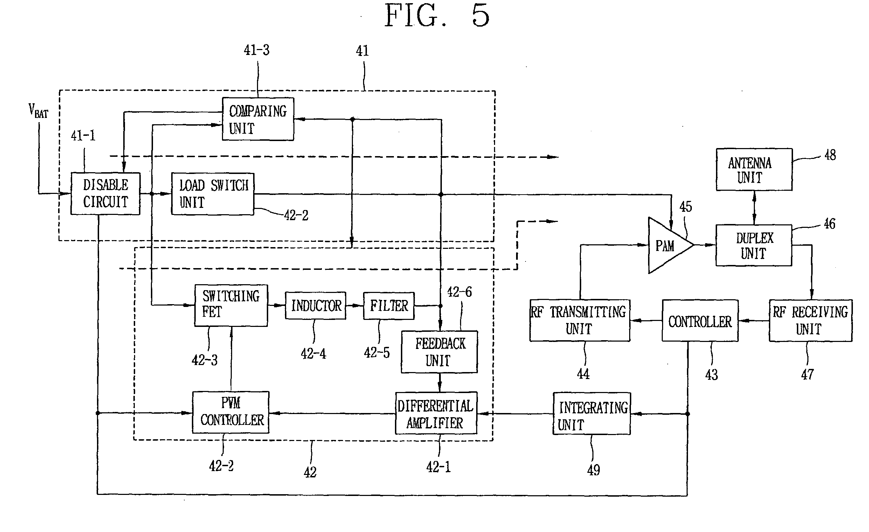

Referring to Fig. 5, the switch unit 41 includes a disable circuit 41-1 for determining whether to supply a PAM driving voltage according to the control signal; a load switch unit 41-2 for supplying the voltage of the battery as the PAM driving voltage by being turned on by the disable circuit 41-1; and a comparing unit 41-3 for comparing the voltage of the battery and the output voltage of the DC/DC converter 42.

The DC/DC converter 42 includes a differential amplifier 42-1, a pulse width modulation (PWM) controller 42-2, a switching FET 42-3, an inductor 42-4, a filter 42-5 and a feedback unit 42-6.

According to an environment in which the terminal is positioned, transmission power requested by the base station differs. The controller 43 can recognize the transmission power based on information included in certain bits of a signal received through the antenna 48, the duplex unit 46 and the RF receiving unit 47.

Upon recognizing the transmission power requested by the base station, the controller 43 outputs a control signal. A driving voltage required for outputting the transmission power requested by the base station is supplied to the PAM 45. The control signal, for example, is a digital signal and can be a pulse duration modulation (PDM) signal.

The control signal outputted from the controller 43 is inputted to an integrating circuit 49. The integrating circuit 49 converts the control signal into a reference voltage. The reference voltage supplies a PAM the driving voltage required to output the requested transmission power by the base station. The control voltage is supplied it to the differential amplifier 42-1. The reference voltage has an analog form and the integrating circuit 49 can be a D/A converter.

Upon receiving the reference voltage from the integrating circuit 49, the differential amplifier 42-1 compares a level of the PAM driving voltage feedback through a feedback unit with the level of the output voltage according to the reference voltage. The differential amplifier 42-1 outputs a differential amplification signal corresponding to the comparison result to the PWM controller 42-2.

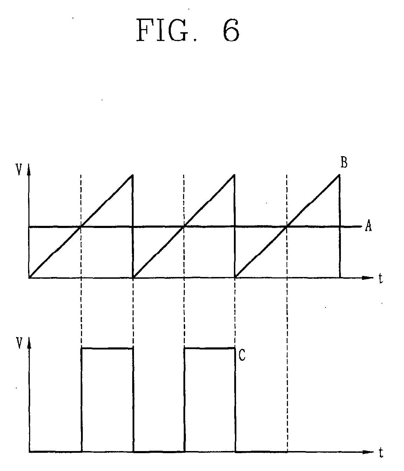

Referring to Fig. 6, upon receiving the differential amplification signal, the PWM controller 42-2 compares a level (A) of the different amplification signal and a saw tooth pulse (B). The PWM controller 42-2 outputs a PWM signal (C) having a duty ratio corresponding to the level (A) of the differential amplification signal. In general, the switching transistor performs ON/OFF operation with a uniform frequency, and a ratio of time during which the switching transistor is ON to an overall time in which the switching transistor is operated in an ON/OFF operation.

The PWM signal is inputted into the switching FET 42-3, and the switching FET 42-3 turns on an internal switching device by using the PWM signal. An output voltage generated as the switching device is turned on is supplied as a driving voltage of the PAM 45 through the inductor 42-4 and the filter 42-5. When the switching device is turned-on by the switching FET 42-3, the inductor 42-4 stores energy. When the switching device is turned-off, the inductor 42-4 operates as a current source for transferring the stored energy to the load (PAM).

The larger the gap between the value of the control signal outputted from the controller 43 and the value of the feedback signal, the higher the level of the differential amplification signal (A). When the level of the differential amplification signal becomes higher, the duty ratio of the PWM signal is reduced inversely proportionally. The output voltage of the switching FET 42-3 is lowered, and as a result, the driving voltage of the PAM 45 is lowered. The driving voltage, for example, of the PAM 45 can be adjusted to a target value according to the value of the control signal outputted from the controller 43.

If a period of the PWM signal is 'T', an interval of time during which the switching device is turned on is TON and a voltage of the battery is VBAT, the output voltage VOUT of the switching FET 42-3 can be expressed as follows:

The voltage VBAT of the battery and the output voltage (PAM driving voltage) VOUT are compared by the comparing unit 41-3. Immediately when the voltage of the battery and the PAM driving voltage are substantially equal, the comparing unit 41-3 stops driving of the DC/DC converter 42. The voltage VBAT of the battery is directly supplied to the PAM 45 through the disable circuit 41-1 and the load switch unit 41-2 of the switch unit 41. The voltage VBAT 41 is the driving voltage of the PAM 45. The disable circuit 41-1 is a switching circuit and determines whether to supply the PAM driving voltage.

In other words, the DC/DC converter 42 is a step down converter, and for a battery voltage greater than an optimum level, the DC/DC converter 42 lowers it to supply to the PAM 45. If the voltage of the battery is optimized, the DC/DC converter stops its operation so that the voltage of the battery can be directly supplied to the PAM 45. After the battery voltage is optimized, if the voltage is too low, a method for raising a voltage to a suitable level can be considered, but in that case, a step-up converter is required.

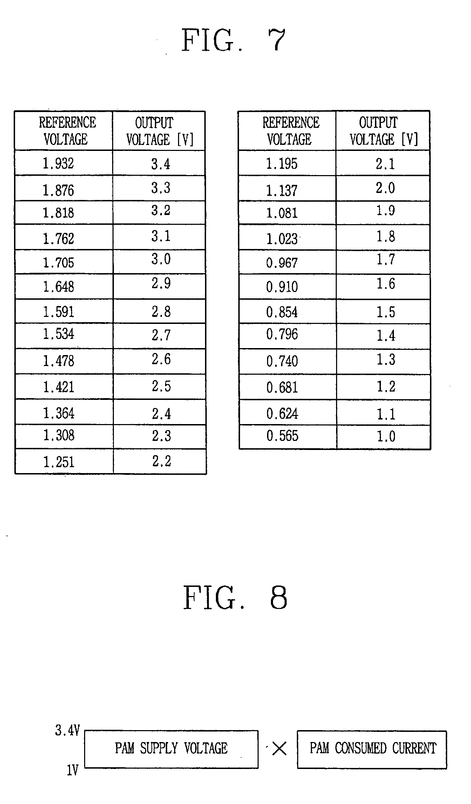

Referring to Fig. 7, after the controller 43 recognizes transmission power requested by the base station, it makes a reference voltage of a corresponding level be outputted through the integrating circuit 49 and a corresponding output voltage be supplied as a driving voltage of the PAM 45.

Referring to Fig. 8, it is noted that the current consumed in the PAM is the same, and in the mobile terminal having the apparatus for controlling the operation power of the PAM in accordance with the present invention, the voltage supplied to the PAM is 3.4V~1V, lower than the PAM supply voltage in the related art (shown in Fig. 2). Thus, the present invention allows the PAM to operate with lower power consumption.

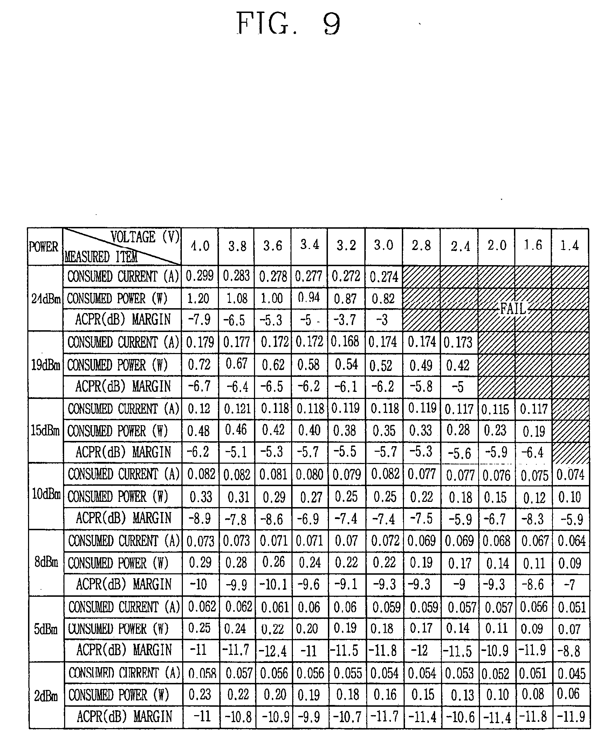

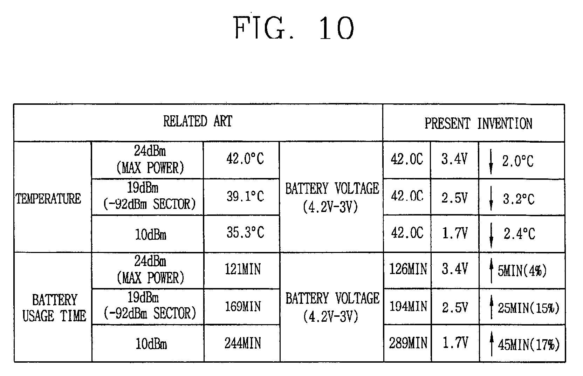

Referring to Fig. 9, it should be noted that the lower the PAM driving voltage causes decreased power consumption. R eferring to Fig. 10, since the mobile terminal of the invention is driven with a lower driving voltage than the conventional mobile terminal, a temperature of the mobile terminal is low. Thus, the mobile terminal battery life is extended compared to a conventional mobile terminal.

In yet another embodiment, a method for controlling power is disclosed. The method comprises outputting a control signal by a controller according to a reference driving voltage corresponding to a requested transmission power, controlling a driving voltage by an adapting unit for an amplifier according to the control signal; and driving the amplifier according to the driving voltage. In one example, a base station may request the transmission power for a mobile terminal.

The method further comprises calculating output power according to power received from the base station, and determining a driving voltage of the amplifier corresponding to the calculated output power. The method also comprises bypassing the driving voltage by a switch according to the control signal, and reducing the driving voltage by a converter according to the control signal.

In another embodiment, the method further comprises comparing using a comparing unit the driving voltage and the reference driving voltage, applying the driving signal to the switch and the converter according to a comparison result, and turning-on the switch and turning-off the converter when the comparison unit calculates the driving voltage and the reference driving voltage become equal.

The following is an example of a mobile communication network using the systems and the method of the present invention.

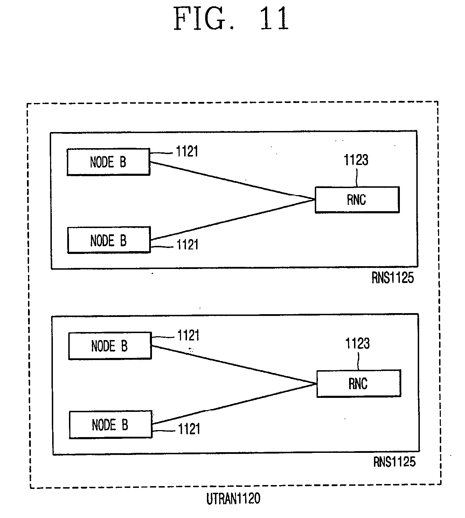

Referring to Fig. 11, the UTRAN 1100 includes one or more radio network subsystems (RNS) 1125. Each RNS 1125 includes a radio network controller (RNC) 1123 and a plurality of Node-Bs (base stations) 1121 managed by the RNC. The RNC 1123 handles the assignment and management of radio resources and operates as an access point with respect to the core network. Furthermore, the RNC 1123 is adapted to perform the methods of the present invention.

The Node-Bs 1121 receive information sent by the physical layer of the terminal through an uplink, and transmit data to the terminal through a downlink. The Node-Bs 1121 operate as access points, or as a transmitter and receiver, of the UTRAN 1100 for the terminal. It will be apparent to one skilled in the art that the mobile communication device may be readily implemented using, for example, the processing unit or other data or digital processing device, either alone or in combination with external support logic.

As an example, the controller is a system for controlling flow of a communication signal. The system comprises a controller for outputting a control signal according to a reference driving voltage corresponding to requested transmission power, an adapting unit for controlling an driving voltage according to the control signal, and an amplifier driven according to the controller driving voltage.

It will be apparent to one skilled in the art that the preferred embodiments of the present invention can be readily implemented using, for example, the processing unit or other data or digital processing device, either alone or in combination with external support logic.

Although the present invention is described in the context of a mobile terminal, the present invention may also be used in any wired or wireless communication systems using mobile devices, such as PDAs and laptop computers equipped with wired and wireless wireless communication capabilities. Moreover, the use of certain terms to describe the present invention should not limit the scope of the present invention to certain type of wireless communication system, such as UMTS. The present invention is also applicable to other wireless communication systems using different air interfaces and/or physical layers, for example, TDMA, CDMA, FDMA, WCDMA, etc.

The preferred embodiments may be implemented as a method, apparatus or article of manufacture using standard programming and/or engineering techniques to produce software, firmware, hardware, or any combination thereof. The term "article of manufacture" as used herein refers to code or logic implemented in hardware logic (e.g., an integrated circuit chip, Field Programmable Gate Array (FPGA), Application Specific Integrated Circuit (ASIC), etc.) or a computer readable medium (e.g., magnetic storage medium (e.g., hard disk drives, floppy disks, tape, etc.), optical storage (CD-ROMs, optical disks, etc.), volatile and non-volatile memory devices (e.g., EEPROMs, ROMs, PROMs, RAMS, DRAMs, SRAMs, firmware, programmable logic, etc.).

Code in the computer readable medium is accessed and executed by a processor. The code in which preferred embodiments are implemented may further be accessible through a transmission media or from a file server over a network. In such cases, the article of manufacture in which the code is implemented may comprise a transmission media, such as a network transmission line, wireless transmission media, signals propagating through space, radio waves, infrared signals, etc. Of course, those skilled in the art will recognize that many modifications may be made to this configuration without departing from the scope of the present invention, and that the article of manufacture may comprise any information bearing medium known in the art.

The logic implementation shown in the figures described specific operations as occurring in a particular order. In alternative implementations, certain of the logic operations may be performed in a different order, modified or removed and still implement preferred embodiments of the present invention. Moreover, steps may be added to the above described logic and still conform to implementations of the invention.

The foregoing embodiments and advantages are merely exemplary and are not to be construed as limiting the present invention. The present teaching can be readily applied to other types of apparatuses. The description of the present invention is intended to be illustrative, and not to limit the scope of the claims. Many alternatives, modifications, and variations will be apparent to those skilled in the art. Accordingly, the invention is not limited to the precise embodiments described in detail hereinabove.

In the claims, means-plus-function clauses are intended to cover the structure described herein as performing the recited function and not only structural equivalents but also equivalent structures. Further, with respect to the claims, it should be understood that any of the claims described below may be combined for the purposes of the invention.

## Claims

1. In a mobile communication system, a system for controlling power supplied to a power amplifier module comprising:
an antenna unit for communicating a signal between a base station and a mobile terminal;
a duplex unit electrically coupled to the antenna unit for separating a transmission frequency from a received frequency of the signal;
an RF receiving unit electrically coupled to the duplex unit and a controller for amplifying and frequency-converting the signal;
a controller for transmitting a control signal to a switch unit and to a DC/DC converter;
a switch unit electrically coupled to the controller for connecting a battery voltage to supply power to the power amplifier module in accordance with a value of the control signal; and
a DC/DC converter electrically coupled to the controller for adjusting the voltage level transmitted from the battery to the power amplifier module in accordance with the value of the control signal.

2. The system of claim 1, wherein the controller receives an output signal of the RF receiving unit, calculates a reference voltage corresponding to a suitable output voltage, and transmits the control signal.

3. The system of claim 2, wherein the reference voltage corresponds to a desired voltage level for transmission of an output signal of a power amplifier.

4. The system of claim 1, wherein the control signal is a digital signal.

5. The system of claim 1, wherein the control signal is a pulse duration modulation signal.

6. The system of claim 1, wherein if the battery voltage equals a desired voltage level determined by the controller, the control signal turns-on the switch unit to supply the battery voltage as a driving voltage for the power amplifier module.

7. The system of claim 1, wherein if the voltage of the battery is greater than a desired voltage level determined by the controller, the DC/DC converter lowers the battery voltage level, and the lowered battery voltage is supplied as a driving voltage for the power amplifier module.

8. The system of claim 1, further comprising:
an RF transmitting unit electrically coupled to the controller and to an input port of power amplifier module for receiving, amplifying, frequency-converting, an output signal of the controller, and outputting an RF transmitter output signal; and
the power amplifier module electrically connected to the RF transmitting unit and the duplex unit for amplifying the RF transmitter output signal.

9. The system of claim 1, wherein the power amplifier module operates upon receiving driving power from at least one of the switch unit and the DC/DC converter.

10. The system of claim 1, wherein the switch unit comprises:
a disable circuit for determining whether to supply a driving voltage of the power amplifier module in accordance with the control signal;
a load switch unit electrically coupled to the disable circuit for supplying the voltage of the battery as the driving voltage when turned-on by the disable circuit; and
a comparing unit electrically coupled to the disable circuit for comparing the voltage of the battery and an output voltage of the DC/DC converter.

11. The system of claim 10, wherein the disable circuit is a switching circuit for determining whether to supply the driving voltage to the power amplifier module.

12. The system of claim 10, wherein the comparing unit compares the voltage of the battery with the output voltage of the DC/DC converter, and if the voltage of the battery is greater than the output voltage of the DC/DC converter, the comparing unit lowers a level of the voltage of the battery to the output voltage of the DC/DC converter, and supplies the voltage of the DC/DC converter to the power amplifier module.

13. The system of claim 11, wherein when the voltage of the battery becomes equal to the output voltage of the DC/DC converter, the controller stops operation of the DC/DC converter and directly supplies the voltage of the battery to the power amplifier module.

14. The system of claim 1, wherein the DC/DC converter is a step-down converter.

15. The system of claim 1, further comprising:
an integrating circuit for receiving a control signal from the controller, converting the control signal into a reference voltage for supplying the PAM driving voltage with a level required for outputting transmission power requested by the base station, and outputting the reference voltage to the DC-DC converter.

16. The system of claim 1, wherein the DC/DC converter comprises:
a differential amplifier for receiving a reference voltage outputted from an integrating circuit and outputting a differential amplification signal;
a pulse width modulation controller electrically connected to the differential amplifier for receiving the differential amplification signal and outputting a pulse width modulation signal;
a switching FET electrically connected to the pulse width modulation controller for turning-on an internal switching device by using the pulse width modulation signal and supplying a generated output voltage as a driving voltage of the PAM;
an inductor electrically connected to the switching FET for storing energy when the switching device is turned-on and transferring the stored energy to a load when the switching device is turned-off;
a filter electrically connected to the inductor for removing ripple or noise of the output voltage; and
a feedback unit for feeding back the level of the driving voltage of the power amplifier module to the differential amplifier.

17. The system of claim 16, wherein the differential amplifier compares the level of the driving voltage of the power amplifier module transmitted through the feedback unit to the level of the output voltage according to the reference voltage, and outputs a differential amplification signal according to the comparison result.

18. The system of claim 17, wherein the pulse width modulation controller compares a level of the differential amplification signal and a saw tooth pulse and outputs a PWM signal having a duty ratio corresponding to the level of the differential amplification signal.

19. The system of claim 1, wherein the controller is a modem located in a mobile station.

20. A signal processing system comprising:
a controller for outputting a control signal according to a reference driving voltage corresponding to requested transmission power;
an adapting unit for controlling a driving voltage for an amplifier according to the control signal; and
the amplifier being driven according to the driving voltage.

21. The system of claim 20, wherein a requested transmission power is transmitted from a base station.

22. The system of claim 20, wherein the controller calculates output power according to power received from the base station and determines a driving voltage of the amplifier corresponding to the calculated output power.

23. The system of claim 20, wherein the adapting unit comprises:
a switch for bypassing the driving voltage according to the control signal; and
a converter for dropping the driving voltage according to the control signal.

24. The system of claim 23, wherein the adapting unit further comprises:
a comparing unit for comparing the driving voltage and the reference driving voltage, and applying the driving signal to the switch and the converter according to the comparison result.

25. The system of claim 22, wherein when the driving voltage and the reference driving voltage become equal, the comparing unit turns on the switch and turns off the converter.

26. A method for signal processing comprising:
outputting a control signal by a controller according to a reference driving voltage corresponding to a requested transmission power;
controlling a driving voltage by an adapting unit for an amplifier according to the control signal; and
driving the amplifier according to the driving voltage.

27. The method of claim 26, further comprising transmitting the requested power from a base station.

28. The method of claim 26, further comprising:
calculating output power according to power received from the base station, and
determining a driving voltage of the amplifier corresponding to the calculated output power.

29. The method of claim 26, further comprising:
bypassing the driving voltage by a switch according to the control signal; and dropping the driving voltage by a converter according to the control signal.

30. The method of claim 26, further comprising:
comparing using a comparing unit the driving voltage and the reference driving voltage; and
applying the driving signal to the switch and the converter according to a comparison result.

31. The method of claim 30, further comprising:
turning-on the switch and turning-off the converter when the comparison unit determines that the driving voltage and the reference driving voltage are approximately equal.

32. A network for radio communication in a mobile communication system, the network comprising:
at least one transmitter for transmitting a communication signal to at least one receiver;
a controller for outputting a control signal according to a reference driving voltage corresponding to a requested transmission power;
an adapting unit for controlling a driving voltage according to the control signal; and
an amplifier being driven according to the driving voltage.

33. The system of claim 32, wherein the requested transmission power is transmitted from a base station.

34. The system of claim 32, wherein the controller calculates output power according to the requested transmission power received from the base station and determines a driving voltage of the amplifier corresponding to the calculated output power.
